# FASCICULE DE BREVET EUROPEEN

(11) **EP 1 094 604 B1**
(45) Date de publication et mention de la délivrance du brevet: **20.12.2006**
(21) Numéro de dépôt: 00470015.9
(22) Date de dépôt: 15.09.2000
(51) Int. Cl.: H03K 17/10, G06K 19/07

(54) **Circuit élévateur de tension de type pompe de charge**
Spannungserhöhungsschaltung des Ladungspumpen-Typs
Voltage boosting circuit of the charge pump type

(30) Priorité: 22.10.1999 FR 9913391
(43) Date de publication de la demande: 25.04.2001
(73) Titulaire: STMicroelectronics S.A., 92120 Montrouge (FR)
(72) Inventeur: Chehadi, Mohamad, Technopôle Metz 2000, 57070 Metz (FR)
(74) Mandataire: Bentz, Jean-Paul

(56) Documents cités:
- EP-A- 0 596 124
- FR-A- 2 752 076
- FR-A- 2 752 318
- US-A- 5 285 370

## Description

L'invention définie dans la revendication indépendante concerne les circuits électroniques dans lesquels il est nécessaire de produire une tension supérieure à une basse tension d'alimentation qui les alimente. L'invention est plus particulièrement applicable aux circuits élévateurs de tension de type pompe de charge utilisés dans les cartes à puce. Un exemple d'un tel circuit est divulgué dans le document FR-A-2 752 318.

Un exemple type d'application d'un circuit utilisant une tension supérieure à sa basse tension d'alimentation est le cas des circuits intégrés comprenant une mémoire non volatile utilisant des transistors à grille flottante et dans lesquels il est nécessaire de disposer d'une haute tension pour programmer et/ou effacer la mémoire. La programmation et/ou l'effacement de ces mémoires exigent en effet une tension de programmation ou d'effacement de l'ordre de 18 V, bien supérieure à la basse tension d'alimentation Vcc qui est par exemple de l'ordre de 3 V.

Pour que l'utilisateur puisse utiliser sa mémoire sans avoir à fournir une haute tension de l'ordre de 18 V, on prévoit que le circuit intégré possède des moyens internes pour produire la haute tension à partir de la basse tension d'alimentation Vcc. Pour cela, on utilise généralement un circuit élévateur de tension dont le principe est basé sur celui de la "pompe de charge".

La figure la illustre schématiquement une structure de pompe de charge connue, comprenant un ensemble de N cellules élémentaires CE₁ à CE_{N} connectées en série. Chaque cellule élémentaire comprend deux bornes d'entrée E1 et E2, deux bornes de sortie S1 et S2 et deux bornes d'entrée d'horloge CK1 et CK2. La haute tension HV est fournie sur la borne de sortie S1 de la N-ième cellule élémentaire.

Les entrées d'horloge CK1 et CK2 des cellules élémentaires CE₁ à CE_{N} reçoivent alternativement quatre signaux de commutation FN1, FN2, FX1 et FX2, produits par un circuit de commande 130 à partir d'un signal d'horloge OSC. Le circuit de commande 130 est alimenté par la tension d'alimentation Vcc du circuit.

Un oscillateur 140 produit le signal d'horloge OSC à partir de la tension d'alimentation Vcc. De manière connue, un oscillateur est réalisé à partir d'inverseurs et de filtres. Il est cependant difficile d'obtenir un oscillateur stable en fréquence.

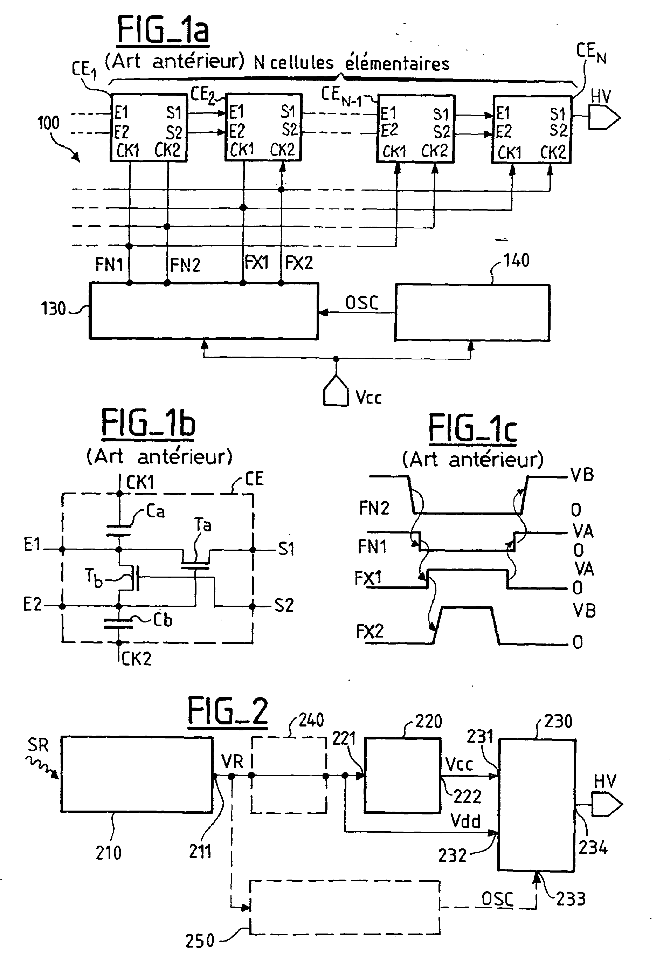

Une cellule élémentaire CE de la pompe de charge, illustrée sur la figure 1b, comprend deux transistors Ta et Tb et deux condensateurs Ca et Cb. Un pôle du condensateur Ca, le drain du transistor Ta et le drain du transistor Tb sont reliés ensemble à la borne d'entrée E1. De même, la grille de commande du transistor Ta, la source du transistor Tb et un pôle du condensateur Cb sont reliés ensemble à la borne d'entrée E2. La source du transistor Ta et la grille de commande du transistor Tb sont connectées respectivement aux bornes de sortie S1 et S2. Enfin, l'autre pôle du condensateur Ca et l'autre pôle du condensateur Cb sont connectés respectivement aux bornes d'entrée d'horloge CK1 et CK2. En pratique, les condensateurs Ca et Cb sont réalisés à partir de transistors, dont la grille de commande correspond à un pôle de ces condensateurs et dont le drain et la source sont reliés ensemble et correspondent à l'autre pôle de ces condensateurs.

Les diagrammes des signaux de commutation FN1, FN2, FX1 et FX2 sont représentés sur la figure 1c. Les premier et troisième signaux de commutation FN1 et FX1 sont deux signaux de commutation complémentaires mais non recouvrants à l'état haut, qui commutent entre deux valeurs qui sont sensiblement 0 et un premier niveau de tension VA. Les second et quatrième signaux de commutation FN2 et FX2, non recouvrants à l'état haut, sont des signaux synchronisés respectivement sur les premier et troisième signaux de commutation FN1, FX1 et qui commutent entre deux valeurs qui sont sensiblement 0 et un second niveau de tension VB. En supposant que les signaux de commutation FN1 et FN2 sont initialement à VA et VB et que les signaux de commutation FX1 et FX2 sont initialement à 0 volt, les signaux de commutation FN1, FN2, FX1 et FX2 sont tels que :
- la descente à 0 V du signal FN2 entraîne la descente à 0 V du signal FN1,
- la descente à 0 V du signal FN1 entraîne la montée à VA du signal FX1,
- la montée à VA du signal FX1 entraîne la montée à VB du signal FX2 qui redescend à 0 V après un délai,
- la descente à 0 V du signal FX2 entraîne la descente à 0 V du signal FX1,
- la descente à 0 V du signal FX1 entraîne la montée à VA du signal FN1,
- la montée à VA du signal FN1 entraîne la montée à VB du signal FN2.

La haute tension HV obtenue, le temps de fonctionnement, les pertes de la pompe de charge ainsi que l'énergie globale qu'elle consomme pour fournir la tension HV, dépendent essentiellement du nombre N de cellules élémentaires, de la tension d'alimentation Vcc, de la tension de seuil VT des transistors Ta, Tb utilisés, et des niveaux de tension VA, VB.

Pour obtenir une haute tension HV suffisante sans augmenter trop le nombre N de cellules élémentaires utilisées, on choisit en général un niveau de tension VA égal à la tension d'alimentation Vcc et un niveau de tension VB le plus élevé possible (VB dépend entre autre du nombre N de cellules élémentaires et de la tension maximale à passer au travers des transistors Ta, Tb). La valeur de VB doit être limitée pour ne pas claquer les oxydes de grilles des transistors. Toutefois, dans la pratique, les circuits de commande utilisés ne permettent pas d'obtenir un niveau de tension VB supérieur à deux fois la tension d'alimentation Vcc.

Le problème de la consommation globale d'énergie de la pompe de charge est plus particulièrement critique pour les applications dites sans contact, pour lesquelles l'énergie totale est fournie à distance par un lecteur sous la forme d'un signal radiofréquence. L'énergie que reçoit la carte est limitée et décroît fortement lorsque la distance entre le lecteur et la carte augmente. Si on souhaite utiliser la carte à une distance raisonnable du lecteur, il est nécessaire de limiter la consommation globale d'énergie des circuits élévateurs de tension de type pompe de charge utilisés dans les applications sans contact.

Dans ce but, l'invention propose une carte à circuit intégré recevant de l'énergie sous la forme d'un signal radiofréquence et comprenant un générateur de tension qui produit une première tension d'alimentation, la carte à circuit intégré étant caractérisée en ce qu'elle comprend en outre un circuit élévateur de tension qui reçoit la première tension d'alimentation sur une première borne d'entrée d'alimentation et une seconde tension d'alimentation supérieure à la première tension d'alimentation sur une seconde borne d'entrée d'alimentation, le circuit élévateur de tension produisant une haute tension.

Selon un mode de réalisation, le générateur de tension comprend un circuit de détection et de redressement qui reçoit le signal radiofréquence et qui produit une tension redressée sur une borne de sortie, et un premier régulateur qui reçoit la tension redressée sur une borne d'entrée d'alimentation et qui produit la première tension d'alimentation, la seconde borne d'entrée d'alimentation du circuit élévateur de tension étant connectée à la borne d'entrée d'alimentation du premier régulateur, la seconde tension d'alimentation (Vdd) étant égale à la tension redressée.

Selon un autre mode de réalisation, le générateur de tension comprend : - un circuit de détection et de redressement qui reçoit le signal radio fréquence et qui produit une tension redressée sur une borne de sortie, - un premier régulateur comprenant une borne d'entrée d'alimentation et produisant la première tension d'alimentation, et - un second régulateur comprenant une borne d'entrée connectée à la borne de sortie du circuit de détection et de redressement pour recevoir la tension redressée et une borne de sortie connectée à la borne d'entrée d'alimentation du premier régulateur, le second régulateur recevant la tension redressée et produisant la seconde tension d'alimentation, le premier régulateur recevant la seconde tension d'alimentation et produisant la première tension d'alimentation.

De préférence, le circuit élévateur de tension comprend un circuit de commande qui produit au moins un couple de signaux de commutation, le premier signal de commutation oscillant entre une tension nulle et un premier niveau de tension, le second signal de commutation oscillant entre une tension nulle et un second niveau de tension. Le circuit de commande reçoit la première et la seconde tensions d'alimentation ; les premier et second niveaux de tension sont obtenus respectivement à partir des première et seconde tensions d'alimentation.

De préférence également, le circuit élévateur de tension comprend en outre N cellules élémentaires connectées en série pour produire la haute tension, les N cellules élémentaires étant commandées par l'au moins un couple de signaux de commutation.

De préférence, le circuit de commande comprend : - un circuit de séparation de phases qui reçoit un signal d'horloge et la première tension d'alimentation et qui produit le premier signal de commutation, et - au moins un circuit de rehaussement qui reçoit le premier signal de commutation et les première et seconde tensions d'alimentation, et qui produit le second signal de commutation par rehaussement du niveau du premier signal de commutation.

Selon un mode de réalisation du circuit élévateur de tension, le circuit de séparation de phase produit également au moins un signal logique représentatif de l'état logique du premier signal de commutation. Les cellules élémentaires sont pilotées soit par l'au moins un couple de signaux de commutation, soit par le premier signal de commutation, et l'au moins un signal logique.

De préférence enfin, la carte à circuit intégré comprend un générateur d'horloge qui reçoit le signal radiofréquence et qui produit le signal d'horloge.

L'invention propose ainsi d'utiliser deux tensions d'alimentation différentes pour alimenter une pompe de charge qui consomme globalement moins d'énergie et également pendant moins longtemps. En effet, en utilisant deux tensions d'alimentation, dont une plus haute que l'autre, l'invention permet d'augmenter le niveau de tension atteint par les signaux de commutation et donc d'augmenter la tension appliquée sur les grilles des transistors des cellules élémentaires de la pompe de charge. La haute tension HV souhaitée est ainsi obtenue plus rapidement et la consommation globale d'énergie est réduite. Le nombre de cellules élémentaires peut même éventuellement être réduit, ce qui diminue d'autant la taille globale, en terme de surface de silicium, du circuit élévateur de tension. De, plus, en utilisant deux tensions d'alimentation, on répartit la puissance consommée par la pompe de charge sur les deux sources de tension qui les produisent ; on limite ainsi le risque d'écroulement de l'une ou l'autre de ces sources.

L'invention est tout particulièrement intéressante pour des cartes à circuit intégré, où il est aisé d'obtenir deux tensions à partir du seul signal radio fréquence reçu par la carte.

Par exemple, pour une carte à puce située à environ 50cm d'un lecteur et en utilisant les solutions actuelles, avec une tension d'alimentation Vcc de l'ordre de 3 V, la pompe de charge consomme de l'énergie pendant environ 50 µs pour fournir une haute tension HV de l'ordre de 18 V. La pompe de charge de l'invention, en utilisant deux tensions d'alimentation, l'une de 3 V et l'autre de 5 V par exemple, ne consomme de l'énergie que pendant 10 µs pour une haute tension HV de l'ordre de 18 V, et ce, sans diminuer la distance entre le lecteur et la carte à puce.

Un autre avantage de l'invention est de supprimer l'oscillateur habituellement utilisé pour fournir le signal d'horloge. Pour cela, on utilise un générateur d'horloge qui produit, à partir du signal radiofréquence de fréquence f0 reçu par la carte, un signal d'horloge de fréquence f = f0 / p, p étant un nombre entier. Classiquement, la fréquence f0 est égale à 13,56 MHz.

Un tel générateur d'horloge présente l'avantage de fournir un signal d'horloge particulièrement stable en fréquence, dans la mesure où la fréquence f0 du signal radiofréquence reçu par la carte est stable. On s'affranchit ainsi des problèmes de stabilité en fréquence de l'oscillateur habituellement utilisé. Dans ce cas, les circuits de la pompe de charge n'ont plus besoin d'être dimensionnés pour supporter des signaux d'horloge de fréquence variable, ce qui permet de réduire la taille globale (en terme de surface de silicium) de la pompe de charge.

De plus, avec un tel générateur d'horloge il est possible de réduire la fréquence du signal d'horloge en choisissant un nombre p supérieur à un, par exemple égal à 8 (soit un signal d'horloge de fréquence f = 1,7 MHz), ce qui permet de réduire encore la consommation globale d'énergie de la pompe de charge.

L'invention sera mieux comprise et d'autres caractéristiques et avantages apparaîtront à la lecture de la description qui va suivre, la description faisant référence aux dessins annexés dans lesquels :
- la figure 1a est un schéma d'un circuit élévateur de tension de type pompe de charge, selon l'art antérieur,
- la figure 1b est un schéma détaillé d'une cellule de base de la pompe de charge de la figure 1a,
- la figure 1c présente des diagrammes des signaux de commutation de la pompe de charge de la figure 1a,
- la figure 2 est un schéma fonctionnel d'une carte à circuit intégré, selon l'invention,
- les figures 3 à 8 sont des schémas électroniques illustrant certains éléments de la figure 2,
- les figures 9a à 9o sont des diagrammes des signaux à différents points des schémas des figures 2 à 7.

Les figures 1a à 1c correspondent à un état de l'art antérieur et ont été décrites précédemment.

La carte à circuit intégré selon l'invention est présentée sur la figure 2. Elle comprend un circuit de détection et de redressement 210, un premier régulateur 220, un circuit élévateur de tension 230 et un second régulateur 240.

Le circuit de détection et de redressement 210 reçoit un signal radiofréquence SR et fournit une tension redressée VR sur une borne de sortie 211 ; il est réalisé selon un schéma connu et comprend notamment une antenne pour recevoir le signal radiofréquence SR et un pont de diodes pour fournir la tension redressée VR. Le circuit de détection et de redressement peut également comprendre des filtres pour améliorer son fonctionnement.

Le circuit élévateur de tension 230, de type pompe de charge, comprend deux bornes d'entrée d'alimentation 231, 232, sur lesquelles sont appliquées une première et une seconde tension d'alimentation Vcc, Vdd. Il comprend également une entrée d'horloge 233 sur laquelle est appliqué un signal d'horloge OSC et il fournit une haute tension HV sur une borne de sortie 234.

Le premier régulateur 220 comprend une borne d'entrée 221 et une borne de sortie 222 connectées respectivement aux bornes d'entrée d'alimentation 232 et 231. Le premier régulateur 220 est réalisé selon un schéma connu, il comprend notamment un détecteur de pension et des filtres pour réguler la première tension d'alimentation Vcc (par exemple à 3 V) qu'il fournit sur sa borne de sortie 222.

Le second régulateur 240 comprend une borne d'entrée connectée à la borne de sortie 211 pour recevoir la tension redressée VR et une borne de sortie connectée à la borne d'entrée 221. Le second régulateur 240 est réalisé selon un schéma connu, de manière similaire au premier régulateur 220. Le second régulateur fournit la seconde tension d'alimentation stable Vdd, par exemple de 4,5 V.

Le second régulateur 240 n'est pas indispensable au fonctionnement de l'invention mais il l'améliore fortement. On peut en effet envisager d'alimenter le circuit élévateur de tension 230 par la première tension d'alimentation Vcc stable et la seconde tension d'alimentation Vdd égale à la tension redressée VR. Cependant, notamment pour des applications pour carte sans contact, le niveau de tension de la tension redressée VR varie très fortement avec la distance entre le lecteur et la carte. Dans ce cas, il serait nécessaire de surdimensionner les éléments du circuit élévateur de tension 230 pour qu'ils supportent les variations de la tension redressée VR. Pour éviter cette contrainte, on préfère utiliser un second régulateur de tension 240 qui fournit une seconde tension d'alimentation Vdd stable.

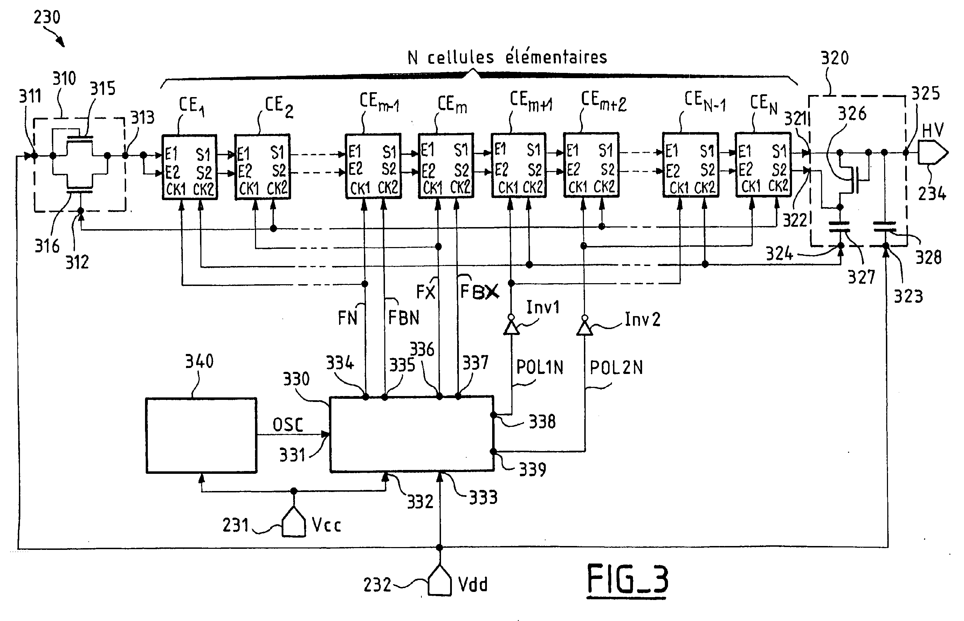

Le circuit élévateur de tension 230 de l'invention est une pompe de charge telle que celle illustrée par la figure 3, c'est-à-dire qu'elle comprend N cellules élémentaires en cascade CE₁ à CE_{N}, chaque cellule élémentaire étant identique à celle de la figure 1b et comprenant deux bornes d'entrée E1 et E2, deux bornes de sortie S1 et S2 et deux bornes d'entrée d'horloge CK1 et CK2. Les entrées E1 et E2 des cellules élémentaires CE₂ à CE_{N} sont reliées respectivement aux sorties S1 et S2 des cellules élémentaires CE₁ à CE_{N-1}

La pompe de charge de la figure 3 comprend également un circuit d'entrée 310, un circuit de sortie 320, un circuit de commande 330 et un oscillateur 340.

Le circuit d'entrée 310 comprend une borne d'entrée d'alimentation 311 connectée à la borne d'entrée d'alimentation 232 du circuit élévateur de tension 230 pour recevoir la seconde tension d'alimentation Vdd, une borne d'entrée d'horloge 312 et une borne de sortie 313. Le circuit d'entrée 310 comprend deux transistors 315 et 316, dont les drains sont reliés ensemble à la borne d'entrée d'alimentation 311 et dont les sources sont connectées ensemble à la borne de sortie 313. La grille de commande du transistor 315 est reliée à son drain pour former une diode et la grille de commande du transistor 316 est connectée à la borne d'entrée d'horloge 312. L'ensemble constitué des transistors 315 et 316 forme un interrupteur CMOS commandé par un signal reçu sur la borne d'entrée d'horloge 312. Les entrées E1 et E2 de la cellule élémentaire CE₁ sont reliées ensemble à la borne de sortie 313 du circuit d'entrée 310.

Le circuit de sortie 320 comprend deux bornes d'entrée 321 et 322 connectées respectivement aux bornes de sortie S1 et S2 de la cellule élémentaire CE_{N}, une borne d'entrée d'alimentation 323 connectée à la borne d'entrée d'alimentation 232 du circuit élévateur de tension 230 pour recevoir la seconde tension d'alimentation Vdd, une borne d'entrée d'horloge 324 et une borne de sortie 325 pour fournir une haute tension HV. Le circuit de sortie 320 comprend un transistor 326 et deux condensateurs 327, 328.

Le drain et la grille de commande du transistor 326 sont connectés ensemble à la borne d'entrée 321 et à la borne de sortie 325 du circuit de sortie 320. La source du transistor 326 est reliée à un pôle du condensateur 327 et à la borne d'entrée 322. L'autre pôle du condensateur 327 est connecté à la borne d'entrée d'horloge 324. Un pôle du condensateur 328 est relié au drain du transistor 326 et son autre pôle est relié à la borne d'entrée d'alimentation 323.

Le circuit de commande 330 comprend une borne d'entrée d'horloge 331 sur laquelle est appliqué un signal d'horloge OSC et deux bornes d'entrée d'alimentation 332 et 333, connectées respectivement aux bornes d'entrée 231 et 232, sur lesquelles sont appliquées respectivement la première et la seconde tensions d'alimentation Vcc, Vdd. Le circuit de commande 330 produit, sur six bornes de sortie d'horloge 334 à 339, quatre signaux de commutation FN, FBN, FX, FBX et deux signaux logiques POL1N, POL2N représentatifs de l'état logique des signaux de commutation FN, FX.

L'oscillateur 340 comprend une borne d'entrée sur laquelle est appliquée la tension d'alimentation Vcc et une borne de sortie connectée à la borne d'entrée 331 du circuit de commande pour fournir le signal d'horloge OSC.

Les entrées d'horloge CK1 et CK2 des cellules élémentaires de rang impair et compris entre 1 et m sont connectées aux bornes de sortie d'horloge 334 et 335 du circuit de commande 330 pour recevoir les signaux de commutation FN et FBN. Les entrées d'horloge CK1 et CK2 des cellules élémentaires de rang pair et compris entre 1 et m sont connectées aux bornes de sortie d'horloge 336 et 337 du circuit de commande 330 pour recevoir les signaux de commutation FX et FBX.

Les entrées d'horloge CK1 et CK2 des cellules élémentaires de rang impair et compris entre m+1 et N sont connectées respectivement à la borne de sortie d'horloge 338 par l'intermédiaire d'un inverseur Inv1, et à la borne de sortie d'horloge 335 du circuit de commande 330. L'entrée d'horloge CK1 des cellules élémentaires de rang impair et compris entre m + 1 et N reçoit ainsi le signal logique POL1N inversé par l'inverseur Inv1. Leur entrée d'horloge CK2 reçoit quant à elle le signal de commutation FBN.

Enfin, les entrées d'horloge CK1 et CK2 des cellules élémentaires de rang pair et compris entre m + 1 et N sont connectées respectivement à la borne de sortie d'horloge 339 par l'intermédiaire d'un inverseur Inv2, et à la borne de sortie d'horloge 337 du circuit de commande 330. L'entrée d'horloge CK1 des cellules élémentaires de rang pair et compris entre m + 1 et N reçoit ainsi le signal logique POL2N inversé par l'inverseur Inv2. Leur entrée d'horloge CK2 reçoit quant à elle le signal de commutation FBX.

Dans l'exemple de la figure 3 décrit ci-dessus, m a été choisi comme étant un nombre entier pair. La cellule élémentaire CEₘ de rang m pair reçoit ainsi les signaux FX et FBX sur ses bornes d'entrée d'horloge CK1 et CK2. La figure 3 n'est cependant qu'un exemple non limitatif de l'invention, et en particulier, m peut être choisi impair. Dans ce cas, la cellule élémentaire CEₘ de rang m impair reçoit les signaux FN et FBN sur ses bornes d'entrée d'horloge CK1 et CK2.

Les signaux de commutation FN et FX sont identiques aux signaux FN1 et FX1 de la figure 1c ; ils sont complémentaires, non recouvrants à l'état haut et commutent entre deux valeurs qui sont 0 et un premier niveau de tension VA qui est égal à la première tension d'alimentation Vcc.

Selon l'invention, les signaux de commutation FBN et FBX sont deux signaux synchronisés respectivement sur les signaux de commutation FN et FX, et commutent entre deux valeurs qui sont 0 et un second niveau de tension VB qui est égal, dans un exemple, à deux fois la tension d'alimentation Vdd, la seconde tension d'alimentation Vdd étant supérieure à la première tension d'alimentation Vcc.

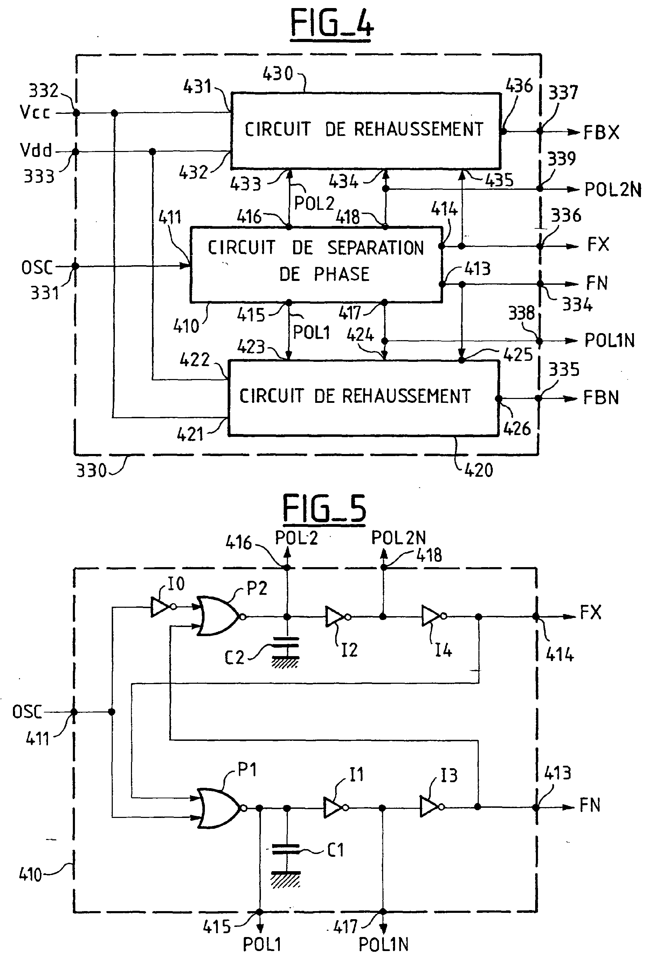

Le circuit de commande 330 comprend, conformément à la figure 4, un circuit de séparation de phase 410 et deux circuits de rehaussement 420 et 430.

Le circuit de séparation de phase 410 comprend une borne d'entrée 411, connectée à la borne d'entrée d'horloge 331 pour recevoir le signal d'horloge OSC et six bornes de sortie 413 à 418 pour fournir les signaux de commutation FN et FX ainsi que quatre signaux logiques POL1, POL2, POL1N, POL2N. Les signaux POL1 et POL1N sont représentatifs de l'état logique du signal de commutation FN et les signaux POL2 et POL2N sont représentatifs de l'état logique du signal de commutation FX. Les bornes de sortie 417 et 418 du circuit de séparation de phases 410 sont connectées aux bornes de sortie 338 et 339 du circuit de commande 330.

Le premier circuit de rehaussement 420 comprend deux bornes d'entrée d'alimentation 421 et 422 connectées respectivement aux bornes d'entrée d'alimentation 332 et 333, et trois bornes d'entrée 423, 424 et 425 connectées respectivement aux bornes de sortie 415, 417 et 413 du circuit de séparation de phase 410 pour recevoir respectivement les signaux POL1, POL1N et FN. Le premier circuit de rehaussement 420 produit le signal de commutation FBN sur une borne de sortie 426 connectée à la borne de sortie 335 du circuit de commande 330.

De même, le second circuit de rehaussement 430 comprend deux bornes d'entrée d'alimentation 431 et 432 connectées respectivement aux bornes d'entrée d'alimentation 332 et 333, et trois bornes d'entrée 433, 434 et 435 connectées respectivement aux bornes de sortie 416, 418 et 414 du circuit de séparation de phase 410 pour recevoir les signaux POL2, POL2N et FX. Le second circuit de rehaussement 430 produit le signal de commutation FBX sur une borne de sortie 436 reliée à la borne de sortie 337 du circuit de commande 330.

Le circuit de séparation de phase 410 comprend, conformément à la figure 5, deux portes logiques P1 et P2, par exemple de type NON-ET, ayant chacune deux bornes d'entrée et une borne de sortie.

Les bornes d'entrée de la porte logique P1 sont connectées respectivement à la borne d'entrée 411 pour recevoir le signal d'horloge OSC et à la borne de sortie 414 du circuit de séparation de phase 410 ; la borne de sortie de la porte logique P1 est connectée à la borne de sortie 415 pour fournir le signal POL1 et à un pôle d'un condensateur C1, l'autre pôle du condensateur C1 étant relié à une masse du circuit de commande 330.

De même, les bornes d'entrée de la porte logique P2 sont connectées respectivement à la borne d'entrée 411 par l'intermédiaire d'un inverseur I0 et à la borne de sortie 413 du circuit de séparation de phase 410 ; la borne de sortie de la porte logique P2 est connectée à la borne de sortie 416 pour fournir le signal POL2 et à un pôle d'un condensateur C2, l'autre pôle du condensateur C2 étant relié à la masse du circuit de commande 330.

Le circuit de séparation de phase 410 comprend également quatre inverseurs I1 à I4, disposant chacun d'une borne d'entrée et d'une borne de sortie. Les inverseurs I3 et I4 sont choisis identiques respectivement aux inverseurs Inv1 et Inv2.

Les inverseurs I1 et I3 sont connectés en série, la borne d'entrée de l'inverseur I1 étant reliée à la borne de sortie de la porte logique P1 et la borne de sortie de l'inverseur I3 étant connectée à la borne de sortie 413 du circuit de séparation de phase 410 pour fournir le signal de commutation FN. La borne de sortie de l'inverseur I1 et la borne d'entrée de l'inverseur I3 sont reliées ensemble à la borne de sortie 417 du circuit de séparation de phase 410 pour fournir le signal POL1N. On notera ici que, conformément à la figure 3, le signal appliqué sur les bornes d'entrée d'horloge CK1 des cellules élémentaires de rang impair et compris entre m + 1 et N, c'est-à-dire le signal POL1N inversé par l'inverseur Inv1, est identique au signal de commutation FN si les inverseurs Inv1 et I3 sont choisis identiques.

Les inverseurs I2 et I4 sont connectés en série, la borne d'entrée de l'inverseur I2 étant reliée à la borne de sortie de la porte logique P2 et la borne de sortie de l'inverseur I4 étant connectée à la borne de sortie 414 du circuit de séparation de phase 410 pour fournir le signal de commutation FX. La borne de sortie de l'inverseur I2 et la borne d'entrée de l'inverseur I4 sont reliées ensemble à la borne de sortie 418 du circuit de séparation de phase 410 pour fournir le signal POL2N. On notera là encore que le signal appliqué sur les bornes d'entrée d'horloge CK2 des cellules élémentaires de rang pair et compris entre m + 1 et N, c'est-à-dire le signal POL2N inversé par l'inverseur Inv2, est identique au signal de commutation FX si les inverseurs Inv2 et I4 sont choisis identiques.

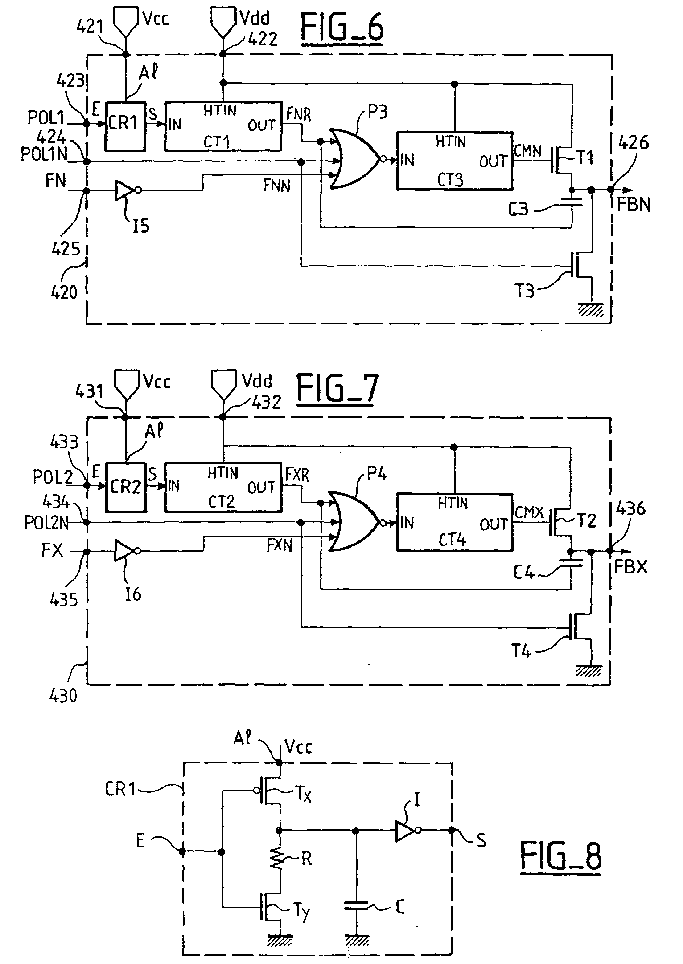

Le premier circuit de rehaussement 420 comprend, conformément à la figure 6, un circuit de retard CR1, deux circuits translateurs de potentiel logique CT1 et CT3, deux transistors T1 et T3, un condensateur C3, une porte logique P3 et un inverseur I5.

Le circuit de retard CR1 comprend, conformément à la figure 8, une borne d'entrée d'alimentation Al sur laquelle est appliquée la première tension d'alimentation Vcc, une borne d'entrée E et une borne de sortie S. Le drain et la source d'un transistor Tx de type P sont connectés respectivement à la borne d'entrée d'alimentation et à une borne d'une résistance R. Le drain et la source d'un transistor Ty sont connectés respectivement à l'autre borne de la résistance R et à la masse du circuit. La grille de commande du transistor Tx et la grille de commande du transistor Ty sont reliées ensemble à la borne d'entrée E du circuit de retard CR1. Une borne d'un condensateur C est reliée à la masse du circuit et son autre borne est connectée à la source du transistor Tx et à la borne d'entrée d'un inverseur I dont la borne de sortie est connectée à la borne de sortie S du circuit de retard CR1.

Le circuit de retard CR1 fonctionne de la manière suivante. Il reproduit sur sa borne de sortie S, le signal qui est appliqué sur sa borne d'entrée E, retardé d'un temps T_{CR.} Un choix approprié de la capacité du condensateur C et de la résistance R permet de fixer la valeur du temps T_{CR}.

Les circuits translateurs de potentiel logique CT1 et CT3 sont identiques ; ils comprennent chacun une borne d'entrée de commande IN, une borne d'entrée d'alimentation HTIN sur laquelle est appliquée la tension d'alimentation Vdd et une borne de sortie OUT.

Un circuit translateur de potentiel fonctionne de la manière suivante. Lorsqu'un signal logique égal à "0" est appliqué sur sa borne d'entrée de commande IN, il produit un signal égal à "0" sur sa borne de sortie OUT. Inversement, lorsqu'un signal logique égal à "1" est appliqué sur sa borne d'entrée de commande IN, il produit un signal dont le niveau est égal au niveau du signal appliqué sur sa borne d'entrée d'alimentation HTIN.

Les circuits translateurs de potentiel CT1 et CT3 permettent ainsi, à partir d'un signal logique basse tension (par exemple de 3 V à l'état haut), de produire un signal logique de plus haute tension (par exemple de 5 V à l'état haut).

La borne d'entrée E du circuit de retard CR1 est connectée à la borne d'entrée 423 du circuit de rehaussement 420 pour recevoir le signal POL1, sa borne d'entrée d'alimentation Al est connectée à la borne d'entrée 421 et sa borne de sortie S est reliée à la borne d'entrée de commande IN du circuit translateur de potentiel CT1.

La porte logique P3 comprend trois bornes d'entrée connectées respectivement à la borne de sortie OUT du circuit translateur de potentiel logique CT1 pour recevoir un signal FNR, à la borne d'entrée 424 du circuit de rehaussement 420 pour recevoir le signal POL1N et à la borne d'entrée 425 du circuit de rehaussement 420 par l'intermédiaire de l'inverseur I5. L'inverseur I5 fournit un signal FNN sur sa borne de sortie. La porte logique P3 comprend également une borne de sortie connectée à la borne d'entrée de commande IN du circuit translateur de potentiel CT3 dont la borne d'entrée d'alimentation HTIN est reliée à borne d'entrée d'alimentation 422 pour recevoir la tension d'alimentation Vdd. La borne de sortie OUT du circuit translateur de potentiel CT3 est reliée à la grille de commande du transistor T1 pour fournir un signal CMN. Le drain du transistor T1 est connecté à la borne d'entrée d'alimentation 422 ; sa source est connectée à la borne de sortie 426 pour fournir le signal de commutation FBN et à un premier pôle du condensateur C3 dont le second pôle est relié à la borne de sortie OUT du circuit translateur de potentiel CT1. Enfin, le drain et la grille de commande du transistor T3 sont connectés respectivement à la borne de sortie 426 et à la borne d'entrée 424 du circuit de rehaussement 420, la source du transistor T3 étant reliée à la masse du circuit.

Le second circuit de rehaussement 430 est identique au premier circuit de rehaussement 420 et il comprend, conformément à la figure 7, un circuit de retard CR2, deux circuits translateurs de potentiel logique CT2 et CT4, deux transistors T2 et T4, un condensateur C4, une porte logique P4 et un inverseur I6.

Le circuit de retard CR2 est identique au circuit de retard CR1. De même, les circuits translateurs de potentiel logique CT2 et CT4 sont identiques aux circuits CT1 et CT3 et leurs bornes d'entrée d'alimentation HTIN sont connectées ensemble à la borne d'entrée 432 pour recevoir la tension d'alimentation Vdd.

La borne d'entrée E du circuit de retard CR2 est connectée à la borne d'entrée 433 du circuit de rehaussement 430 pour recevoir le signal POL2, sa borne d'entrée d'alimentation Al est connectée à la borne d'entrée 431 et sa borne de sortie S est reliée à la borne d'entrée de commande IN du circuit translateur de potentiel CT2.

La porte logique P4 comprend trois bornes d'entrée connectées respectivement à la borne de sortie OUT du circuit translateur de potentiel logique CT2 pour recevoir un signal FXR, à la borne d'entrée 434 du circuit de rehaussement 430 pour recevoir le signal POL2N et à la borne d'entrée 435 du circuit de rehaussement 430 par l'intermédiaire de l'inverseur I6. L'inverseur I6 fournit un signal FXN sur sa borne de sortie. La porte logique P4 comprend également une borne de sortie connectée à la borne d'entrée de commande IN du circuit translateur de potentiel CT4 dont la borne de sortie OUT est reliée à la grille de commande du transistor T2 pour fournir un signal CMX. Le drain du transistor T2 est connecté à la borne d'entrée d'alimentation 432 ; sa source est connectée à la borne de sortie 436 pour fournir le signal de commutation FBX et à un premier pôle du condensateur C4 dont le second pôle est relié à la borne de sortie OUT du circuit translateur de potentiel CT2. Enfin, le drain et la grille de commande du transistor T4 sont connectés respectivement à la borne de sertie 436 et à la borne d'entrée 434 du circuit de rehaussement 430, la source du transistor T4 étant reliée à la masse du circuit.

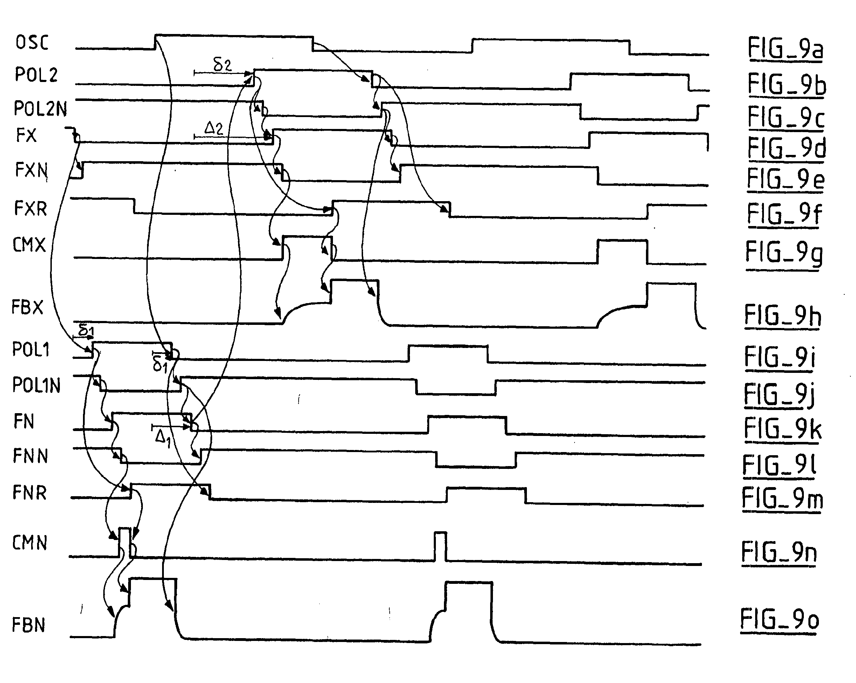

Le fonctionnement du circuit de commande 330 va maintenant être décrit en relation avec les figures 9a à 9o qui sont des diagrammes des signaux en différents points du circuit 330.

Les signaux OSC, POL1, POL1N, FN, FNN, POL2, POL2N, FX et FXN sont des signaux logiques qui commutent entre une pension nulle et la première tension d'alimentation Vcc, Vcc étant de l'ordre de 3 V par exemple.

Les signaux FNR, CMN, FXR et CMX sont des signaux logiques qui commutent entre une tension nulle et la tension d'alimentation Vdd, Vdd étant de l'ordre de 5 V par exemple. Les signaux de commutation FBN et FBX varient quant à eux entre une tension nulle et le second niveau de tension VB qui est de d'ordre de 2*Vdd.

Four l'exemple qui suit, on supposera qu'initialement :
- les signaux OSC, POL1, FN, FNR, CMN, FBN, POL2, FXN, CMX et FBX sont égaux à un "0" logique, c'est à dire qu'ils sont nuls,
- les signaux FX, POL1N, POL2N et FNN sont égaux à un "1" logique, c'est-à-dire qu'ils sont au potentiel Vcc, et
- le signal FXR est égal à un "1" logique, c'est-à-dire qu'il est au potentiel Vdd.

On supposera également que les inverseurs I1 à I6 sont identiques et introduisent un léger retard δ, et que les condensateurs C1 et C2 introduisent des retards δ1 et δ2.

Le passage à "0" du signal de commutation FX entraîne le passage à "1" du signal FXN, avec un léger décalage δ introduit par l'inverseur I6. En parallèle, le signal POL1 passe à "1" avec un retard δ1 introduit par le condensateur C1.

Le passage à "1" du signal POL1 entraîne le passage à "0" du signal POL1N, le passage à "1" du signal de commutation FN, et le passage à "0" du signal FNN, les signaux POL1N, FN et FNN changeant d'état l'un après l'autre, chaque fois avec un léger décalage δ dû à la présence des inverseurs I1, I3 et I5. Le passage à "0" du signal de commutation FX entraîne ainsi le passage à "1" du signal FN avec un retard Δ1 = δ1 + 2*δ, dû au condensateur C1 et aux inverseurs I1 et I3.

Les signaux FNR et POL1N étant nuls, le passage à "0" du signal FNN entraîne le changement d'état sur la borne de sortie de la porte P3 et le passage à "1" du signal CMN par l'intermédiaire du circuit translateur de potentiel CT3. Le signal CMN est donc porté au potentiel Vdd, ce qui rend passant le transistor T1 et le signal de commutation FBN est porté au potentiel Vdd. De plus, le signal POL1N étant égal à "0", une des bornes du condensateur C3 est à un potentiel nul, son autre borne étant au potentiel Vdd, le condensateur C3 se charge donc.

En parallèle, le passage à "1" du signal POL1 entraîne le passage à "1" du signal FNR avec un retard dû à la présence du circuit de retard CR1, le signal FNR est donc porté au potentiel Vdd par l'action du circuit translateur de potentiel CT1.

Le signal FNR étant au potentiel Vdd, la sortie de la porte logique P3 change d'état, le signal CMN passe à "0" et le transistor T1 se bloque. Le condensateur C3 étant chargé et le signal FNR étant porté au potentiel Vdd, l'autre borne du condensateur C3 grimpe au potentiel VB = 2*Vdd, ainsi que le signal de commutation FBN.

Peu après, le signal OSC passe de "0" à "1", la sortie de la porte logique P1 change d'état et le signal POL1 passe à "0" avec un retard δ1 introduit par le condensateur C1. Le passage à "0" du signal POL1 entraîne le passage à "1" du signal POL1N, le passage à "0" du signal FN et le passage à "1" du signal FNN, les signaux POL1N, FN et FNN changeant d'état successivement avec chaque fois un léger décalage δ dû à la présence des inverseurs I1, I3 et I5. Le changement d'état du signal OSC entraîne ainsi le changement d'état du signal de commutation FN avec un retard Δ1 = δ1 + 2*δ, dû au condensateur C1 et aux inverseurs I1 et I3.

Le passage à "0" du signal de commutation FN entraîne le passage à "1" du signal FNN, avec un léger décalage δ introduit par l'inverseur I5. En parallèle, le signal POL2 en sortie de la porte logique P2 passe à "1" avec un retard δ2 introduit par le condensateur C2.

Le passage à "1" du signal POL2 entraîne le passage à "0" du signal POL2N, le passage à "1" du signal de commutation FX, et le passage à "0" du signal FXN, les signaux POL2N, FX et FXN changeant d'état l'un après l'autre, chaque fois avec un léger décalage δ dû à la présence des inverseurs I2, I4 et I6. Le passage à "0" du signal de commutation FN entraîne ainsi le passage à "1" du signal FX avec un retard Δ2 = δ2 + 2*δ, dû au condensateur C2 et aux inverseurs I2 et I4.

Les signaux FXR et POL2N étant nuls, le passage à "0 du signal FXN entraîne le changement d'état sur la borne de sortie de la porte P4 et le passage à "1" du signal CMX par l'intermédiaire du circuit translateur de potentiel CT4. Le signal CMX est donc porté au potentiel Vdd, ce qui rend passant le transistor T2 et le signal de commutation FBX est porté au potentiel Vdd. De plus, le signal POL2N étant égal à "0", une des bornes du condensateur C4 est à un potentiel nul, son autre borne étant au potentiel Vdd, le condensateur C4 se charge donc.

En parallèle, le passage à "1" du signal POL2 entraîne le passage à "1" du signal FXR avec un retard dû à la présence du circuit de retard CR2, le signal FXR est donc porté au potentiel Vdd par l'action du circuit translateur de potentiel CT2.

Le signal FXR étant au potentiel Vdd, la sortie de la porte logique P4 change d'état, le signal CMX passe à "0" et le transistor T2 se bloque. Le condensateur C4 étant chargé et le signal FXR étant porté au potentiel Vdd, l'autre borne du condensateur C4 grimpe au potentiel VB = 2*Vdd, ainsi que le signal de commutation FBX.

Peu après, le signal OSC passe de "1" à "0", la sortie de la porte logique P2 change d'état et le signal POL2 passe à "0" avec un retard δ1 introduit par le condensateur C2. Le passage à "0" du signal POL2 entraîne le passage à "1" du signal POL2N, le passage à "0" du signal FX et le passage à "1" du signal FXN, les signaux POL2N, FX et FXN changeant d'état successivement avec chaque fois un léger décalage δ dû à la présence des inverseurs I2, I4 et I6. Le changement d'état du signal OSC entraîne ainsi le changement d'état du signal de commutation FX avec un retard Δ2 = δ2 + 2*δ, dû au condensateur C2 et aux inverseurs I2 et I4. Le circuit de commande 200 est alors revenu dans son état initial.

Selon une variante de la pompe de charge de l'invention, il est possible d'alimenter toutes les cellules élémentaires de la pompe de charge soit par les signaux de commutation FN et FBN soit par les signaux de commutation FX et FBX. Pour cela on supprime les inverseurs Inv1 Inv2 ainsi que les bornes de sortie 338, 339 du circuit de commande 330 et les connexions reliant ces bornes de sortie aux cellules élémentaires CEₘ₊₁ à CE_{N}.

Ainsi, selon cette variante, les entrées d'horloge CK1 et CK2 des cellules élémentaires de rang impair et compris entre m + 1 et N sont connectées respectivement aux bornes de sortie d'horloge 334 et 335 du circuit de commande 330 pour recevoir les signaux de commutation FN et FBN. Enfin, les entrées d'horloge CK1 et CK2 des cellules élémentaires de rang pair et compris entre m + 1 et N sont connectées respectivement aux bornes de sortie d'horloge 336 et 337 du circuit de commande 330 et elles reçoivent les signaux de commutation FX et FBX. Les cellules élémentaires de rang 1 à m reçoivent les mêmes signaux que précédemment.

Cette variante est moins performante que la variante illustrée par la figure 3 car, si on supprime les inverseurs Inv1 et Inv2, les courants qui les traversaient pour alimenter les cellules élémentaires CEₘ₊₁ à CE_{N} vont s'additionner aux courants traversant les inverseurs I3 et I4. Les inverseurs I3 et I4 devront donc être dimensionnés de taille plus importante pour pouvoir supporter des puissances plus importantes ainsi que des pointes de courant plus fortes lors du changement d'état logique des inverseurs I3 et I4.

L'invention peut être améliorée en supprimant l'oscillateur 340 du circuit élévateur de tension 230 et en le remplaçant par un générateur d'horloge 250 (représenté en pointillés sur la figure 2) qui comprend une borne d'entrée connectée à la borne de sortie 211 du circuit de détection et de redressement 210 et une borne de sortie connectée à la borne d'entrée d'horloge 233 du circuit élévateur de tension 230. Le générateur d'horloge 250 fournit à partir de la tension redressée VR, un signal d'horloge OSC de fréquence f = f0/p, f0 étant la fréquence du signal radiofréquence SR reçu par la carte et p étant un nombre entier. Classiquement, f0 est égale à 13,56MHz. En choisissant par exemple p = 8, on obtient un signal d'horloge de fréquence f = 1,7 MHz.

Un tel générateur d'horloge présente l'avantage d'être particulièrement stable en fréquence, dans la mesure où la fréquence f0 du signal radiofréquence SR émis par le lecteur est stable. On s'affranchit ainsi des problèmes de stabilité de l'oscillateur classique 340.

## Revendications

1. Carte à circuit intégré recevant de l'énergie sous la forme d'un signal radiofréquence (SR), la dite carte comprenant un générateur de tension (210, 220) pour produire une première tension d'alimentation (Vcc), et un circuit élévateur de tension (230) comprenant :
un circuit de commande (330) pour produire au moins un couple de signaux de commutation ((FN, FBN), (FX, FBX)), le premier signal de commutation (FN, FX) oscillant entre une tension nulle et un premier niveau de tension (VA), le second signal de commutation (FBN, FBX) oscillant entre une tension nulle et un second niveau de tension (VB),
N cellules élémentaires (CE₁ à CE_{N}) connectées en série pour produire une haute tension (HV), les N cellules élémentaires étant commandées par l'au moins un couple de signaux de commutation ((FN, FBN), (FX, FBX)),
la carte étant **caractérisée en ce que** le premier niveau de tension (VA) et le second niveau de tension (VB) sont obtenus respectivement à partir de la première tension d'alimentation (Vcc) et d'une seconde tensions d'alimentation (Vdd) supérieure à la première tension d'alimentation.

2. Carte à circuit intégré selon la revendication 1, **caractérisée en ce que** le générateur de tension (210, 220) comprend :
- un circuit de détection et de redressement (210) qui reçoit le signal radiofréquence (SR) et qui produit une tension redressée (VR) sur une borne de sortie (211), et
- un premier régulateur (220) qui reçoit la tension redressée (VR) sur une borne d'entrée d'alimentation (221) et qui produit la première tension d'alimentation (Vcc), la seconde borne d'entrée d'alimentation (232) du circuit élévateur de tension (230) étant connectée à la borne d'entrée d'alimentation (221) du premier régulateur (220), la seconde tension d'alimentation (Vdd) étant égale à la tension redressée.

3. Carte à circuit intégré selon la revendication 1, **caractérisée en ce que** le générateur de tension (210, 220, 240) comprend :
- un circuit de détection et de redressement (210) qui reçoit le signal radio fréquence (SR) et qui produit une tension redressée (VR) sur une borne de sortie (211),
- un premier régulateur (220) comprenant une borne d'entrée d'alimentation (221) et produisant la première tension d'alimentation (Vcc), et
- un second régulateur (240) comprenant une borne d'entrée connectée à la borne de sortie (211) du circuit de détection et de redressement (210) pour recevoir la tension redressée (VR) et une borne de sortie connectée à la borne d'entrée d'alimentation (221) du premier régulateur (220), le second régulateur (240) recevant la tension redressée (VR) et produisant la seconde tension d'alimentation (Vdd), le premier régulateur (220) recevant la seconde tension d'alimentation (Vdd) et produisant la première tension d'alimentation (Vcc).

4. Carte à circuit intégré selon l'une des revendications 1 à 3, dans laquelle le circuit de commande (330) comprend :
- un circuit de séparation de phases (410) qui reçoit un signal d'horloge (OSC) et 1a première tension d'alimentation (Vcc) et qui produit le premier signal de commutation (FN, FX), et
- au moins un circuit de rehaussement (420, 430) qui reçoit le premier signal de commutation (FN, FX) et les première (Vcc) et seconde (Vdd) tensions d'alimentation, et qui produit le second signal de commutation (FBN, FBX) par rehaussement du niveau du premier (FN, FX) signal de commutation.

5. Carte à circuit intégré selon la revendication 4, dans laquelle le circuit de séparation de phase (410) produit également au moins un signal logique (POL1N, POL2N) représentatif de l'état logique du premier (FN, FX) signal de commutation.

6. Carte à circuit intégré selon la revendication 5, dans laquelle les cellules élémentaires (CE₁ à CE_{N}) sont pilotées soit par l'au moins un couple de signaux de commutation ((FN, FBN), (FX, FBX))soit par le premier signal de commutation (FN, FX) et l'au moins un signal logique (POL1N, pOL2N).

7. Carte à circuit intégré selon l'une des revendications 4 à 6, **caractérisée en ce que** l'au moins un circuit de rehaussement (420, 430) comprend :
- des moyens (I5, I6) pour retarder le premier signal de commutation (FN, FX),
- des moyens (T1, T2) pour précharger un second pôle de condensateur (C3, C4) à la seconde tension d'alimentation (Vdd),
- des moyens (P3, CT3, P4, CT4) pour rehausser le niveau atteint par le second pôle de condensateur (C3, C4), et
- des moyens (T3, T4) pour ramener le second pôle de condensateur (C3, C4) à la tension nulle,
le deuxième (FBN, FBX) signal de commutation étant fourni sur le second pôle de condensateur (C3, C4).

8. Carte à circuit intégré selon l'une des revendications 4 à 7, comprenant un générateur d'horloge (250) qui reçoit le signal radiofréquence (SR) et qui produit le signal d'horloge (OSC).

## Claims

1. Integrated circuit board which receives energy in the form of a radiofrequency signal (SR), the said board comprising a voltage generator (210, 220) in order to produce a first supply voltage (Vcc), and a voltage-increasing circuit (230) comprising:
a control circuit (330) in order to produce at least one pair of switching signals ((FN, FBN), (FX, FBX)), the first switching signal (FN, FX) oscillating between a zero voltage and a first voltage level (VA), the second switching signal (FBN, FBX) oscillating between a zero voltage and a second voltage level (VB);
N elementary cells (CE₁ to CE_{N}) connected in series in order to produce a high voltage (HV), the N elementary cells being controlled by at least one pair of switching signals ((FN, FBN), (FX, FBX)),
the board being **characterised in that** the first voltage level (VA) and the second voltage level (VB) are obtained respectively from the first supply voltage (Vcc) and a second supply voltage (Vdd) which is greater than the first supply voltage.

2. Integrated circuit board according to claim 1, **characterised in that** the voltage generator (210, 220) comprises:
- a detection and rectifying circuit (210) which receives the radiofrequency signal (SR) and produces a rectified voltage (VR) at an output terminal (211); and
- a first regulator (220) which receives the rectified voltage (VR) at a supply input terminal (221) and produces the first supply voltage (Vcc), the second supply input terminal (232) of the voltage-increasing circuit (230) being connected to the supply input terminal (221) of the first regulator (220), and the second supply voltage (Vdd) being equal to the rectified voltage.

3. Integrated circuit board according to claim 1, **characterised in that** the voltage generator (210, 220, 240) comprises:
- a detection and rectifying circuit (210) which receives the radiofrequency signal (SR) and produces a rectified voltage (VR) at an output terminal (211); and
- a first regulator (220) comprising a supply input terminal (211) and producing the first supply voltage (Vcc); and
- a second regulator (240) comprising an input terminal which is connected to the output terminal (211) of the detection and rectifying circuit (210) in order to receive the rectified voltage (VR) and an output terminal which is connected to the supply input terminal (221) of the first regulator (220), the second regulator (240) receiving the rectified voltage (VR) and producing the second supply voltage (Vdd), and the first regulator (220) receiving the second supply voltage (Vdd) and producing the first supply voltage (Vcc).

4. Integrated circuit board according to any one of claims 1 to 3, wherein the control circuit (330) comprises:
- a phase separation circuit (410) which receives a clock signal (OSC) and the first supply voltage (Vcc) and which produces the first switching signal (FN, FX); and
- at least one increasing circuit (420, 430) which receives the first switching signal (FN, FX) and the first (Vcc) and second (Vdd) supply voltages, and which produces the second switching signal (FBN, FBX) by increasing the level of the first (FN, FX) switching signal.

5. Integrated circuit board according to claim 4, wherein the phase separation circuit (410) also produces at least one logic signal (POL1N, POL2N) which is representative of the logic stage of the first (FN, FX) switching signal.

6. Integrated circuit board according to claim 5, wherein the elementary cells (CE₁ to CE_{N}) are piloted either by the at least one pair of switching signals ((FN, FBN), (FX, FBX)), or by the first switching signal (FN, FX) and the at least one logic signal (POL1N, POL2N).

7. Integrated circuit board according to any one of claims 4 to 6, **characterised in that** the at least one increasing circuit (420, 430) comprises:
- means (I5, I6) for delaying the first switching signal (FN, FX);
- means (T1, T2) for pre-charging a second capacitor pole (C3, C4) to the second supply voltage (Vdd);
- means (P3, CT3, P4, CT4) for increasing the level reached by the second capacitor pole (C3, C4); and
- means (T3, T4) for bringing the second capacitor pole (C3, C4) down to zero voltage;
the second (FBN, FBX) switching signal being supplied to the second capacitor pole (C3, C4).

8. Integrated circuit board according to any one of claims 4 to 7, comprising a clock (250) which receives the radiofrequency signal (SR) and produces the clock signal (OSC).

## Patentansprüche

1. Integrierte Schaltkreiskarte, die Energie in Form eines Hochfrequenzsignals (SR) empfängt, wobei die Karte einen Spannungsgenerator (210, 220) aufweist, um eine erste Versorgungsspannung (Vcc) zu erzeugen und eine Spannungserhöhungsschaltung (230) mit:
einem Steuerkreis (330), um zumindest ein Paar Schaltsignale (FN, FBN), (FX, FBX) zu erzeugen, wobei das erste Schaltsignal (FN, FX) zwischen einer Nullspannung und einem ersten Spannungspegel (VA) schwankt und das zweite Schaltsignal (FBN, FBX) zwischen einer Nullspannung und einem zweiten Spannungspegel (VB) schwankt,
N Elementarzellen (CE₁ bis CE_{N}), die in Serie geschaltet sind, um eine hohe Spannung (HV) zu erzeugen, wobei die N Elementarzellen von zumindest einem Paar Schaltsignale (FN, FBN), (FX, FBX) gesteuert werden,
wobei die Karte **dadurch gekennzeichnet ist, dass** der erste Spannungspegel (VA) und der zweite Spannungspegel (VB) jeweils ausgehend von der ersten Versorgungsspannung (Vcc) und einer zweiten Versorgungsspannung (Vdd) erhalten werden, die höher ist als die erste Versorgungsspannung.

2. Integrierte Schaltkreiskarte gemäß Anspruch 1, **dadurch gekennzeichnet, dass** der Spannungsgenerator (210, 220) aufweist:
- eine Erfassungs- und Richtschaltung (210), welche das Hochfrequenzsignal (SR) empfängt, und welche eine gerichtete Spannung (VR) an einer Ausgangsklemme (211) erzeugt, und
- einen ersten Regler (220), der die gerichtete Spannung (VR) an einer Versorgungseingangsklemme (221) empfängt, und der die erste Versorgungsspannung (Vcc) erzeugt, wobei die zweite Versorgungseingangsklemme (232) der Spannungserhöhungsschaltung (230) an die Versorgungseingangsklemme (221) des ersten Reglers (220) angeschlossen ist, wobei die zweite Versorgungsspannung (Vdd) gleich der gerichteten Spannung ist.

3. Integrierte Schaltkreiskarte gemäß Anspruch 1, **dadurch gekennzeichnet, dass** der Spannungsgenerator (210, 220, 240) aufweist:
- eine Erfassungs- und Richtschaltung (210), welche das Hochfrequenzsignal (SR) empfängt, und welche eine gerichtete Spannung (VR) an einer Ausgangsklemme (211) erzeugt,
- einen ersten Regler (220) mit einer Versorgungseingangsklemme (221), der die erste Versorgungsspannung (Vcc) erzeugt, und
- einen zweiten Regler (240) mit einer Eingangsklemme, die an die Ausgangsklemme (211) der Erfassungs- und Richtschaltung (210) angeschlossen ist, um die gerichtete Spannung (VR) zu empfangen, und mit einer Ausgangsklemme, die an die Versorgungseingangsklemme (221) des ersten Reglers (220) angeschlossen ist, wobei der zweite Regler (240) die gerichtete Spannung (VR) empfängt und die zweite Versorgungsspannung (Vdd) erzeugt, wobei der erste Regler (220) die zweite Versorgungsspannung (Vdd) empfängt und die erste Versorgungsspannung (Vcc) erzeugt.

4. Integrierte Schaltkreiskarte gemäß einem der Ansprüche 1 bis 3, wobei der Steuerkreis (330) aufweist:
- eine Phasentrennschaltung (410), die ein Taktsignal (OSC) und die erste Versorgungsspannung (Vcc) empfängt, und die das erste Schaltsignal (FN, FX) erzeugt, und
- zumindest eine Erhöhungsschaltung (420, 430), die das erste Schaltsignal (FN, FX) und die erste (Vcc) und die zweite (Vdd) Versorgungsspannung empfängt, und die das zweite Schaltsignal (FBN, FBX) durch Erhöhung des Pegels des ersten Schaltsignals (FN, FX) erzeugt.

5. Integrierte Schaltkreiskarte gemäß Anspruch 4, wobei die Phasentrennschaltung 410) ebenfalls zumindest ein logisches Signal (POL1N, POL2N) erzeugt, das repräsentativ für den logischen Zustand des ersten Schaltsignals (FN, FX) ist.

6. Integrierte Schaltkreiskarte gemäß Anspruch 5, wobei die Elementarzellen (CE₁ bis CE_{N}) entweder von zumindest einem Paar Schaltsignale (FN, FBN), (FX, FBX) oder von dem ersten Schaltsignal (FN, FX) und zumindest einem logischen Signal (POL1N, POL2N) ferngesteuert werden.

7. Integrierte Schaltkreiskarte gemäß einem der Ansprüche 4 bis 6, **dadurch gekennzeichnet, dass** die zumindest eine Erhöhungsschaltung (420, 430) aufweist:
- Vorrichtungen (15, 16) zum Verzögern des ersten Schaltsignals (FN, FX),
- Vorrichtungen (T1, T2) zum Vorladen eines zweiten Kapazitätspols (C3, C4) mit der zweiten Versorgungsspannung (Vdd),
- Vorrichtungen (P3, CT3, P4, CT4) zum Erhöhen des von dem zweiten Kapazitätspols (C3, C4) erreichten Pegels, und
- Vorrichtungen (T3, T4) zum Rückführen des zweiten Kapazitätspols (C3, C4) auf die Nullspannung,
wobei das zweite Schaltsignal (FBN, FBX) zu dem zweiten Kapazitätspol (C3, C4) geliefert wird.

8. Integrierte Schaltkreiskarte gemäß einem der Ansprüche 4 bis 7 mit einem Taktgenerator (250), der das Hochfrequenzsignal (SR) empfängt, und der das Taktsignal (OSC) erzeugt.
